# EUROPEAN PATENT SPECIFICATION

(11) **EP 1 909 297 B1**
(45) Date of publication and mention of the grant of the patent: **14.12.2016**
(21) Application number: 07114571.8
(22) Date of filing: 17.08.2007
(51) Int. Cl.: H01F 6/04, G01R 33/3815, F25D 19/00

(54) **Flow-cooled magnet system**
Strömungsgekühltes Magnetsystem
Système magnétique refroidi par flux

(30) Priority: 04.10.2006 GB 0619607
(43) Date of publication of application: 09.04.2008
(73) Proprietor: Oxford Instruments Nanotechnology Tools Limited, Oxon OX13 5QX (GB)
(72) Inventor: Ghoshal, Probir Kumar, Witney, Oxon OX28 1FF (GB); Bateman, Rod, Witney, Oxon OX28 1DU (GB)
(74) Representative: Gill Jennings & Every LLP

(56) References cited:
- EP-A- 1 760 480
- WO-A-03/023433
- US-A- 5 485 730
- US-A1- 2005 068 034
- US-A1- 2006 097 146
- US-A1- 2006 130 493
- US-B1- 6 641 701

## Description

### Field of the Invention

The present invention relates to a flow-cooled magnet system.

### Background to the Invention

In many applications it is desirable to subject a "target" (including devices, other apparatus, an experimental sample or indeed an organism), to a controlled magnetic field. As is known, the strongest magnetic fields are at present generated electromagnets, cooled to cryogenic temperatures. Depending upon the application in question, the target may also be cooled to cryogenic temperatures (for example in the case of very sensitive devices), to an intermediate temperature or indeed the level of cooling may be minimal such that the target temperature is that of approximately ambient temperature.

The cooling systems required for maintaining such magnets at operative temperatures are often substantial. In addition, in order to cool the target, cooling systems of a different nature are used, often because of the different temperature requirements, the location of the target within the confines of a cryostat bore and in some cases due to the removable nature of the target from the system.

Known systems are often bulky and many require the warming of the magnet itself in order to exchange targets. There is therefore a need to improve upon known systems in order to address such deficiencies.

EP1760480 describes NMR apparatus in which a magnet contained in a bath is cooled by a cryogenic fluid and flow of the fluid from the bath is used to cool the NMR probe head.

US2006/0130493 similarly describes a magnet system in which a magnet is contained within a bath of cryogenic fluid and part of the fluid is removed from the bath so as to cool an NMR head.

### Summary of the Invention

In accordance with the present invention we provide a flow-cooled magnet system comprising:-
a magnet for generating a magnetic field in a target region;
a cooling system comprising a flow path for a cryogenic coolant fluid, the flow path having:-
   (i) a first part arranged in thermal communication with the magnet, wherein the magnet is cooled by thermal conduction and wherein the magnet is separated from the cyogenic coolant by a high thermal conductivity member through which heat flows from the magnet; and,
   (ii) a second part in thermal communication with the target region,
   the system being arranged such that each of the magnet and target region are cooled by the flow of coolant in the first and second parts of the cooling system.

We have realised that, by appropriate design, a system can be produced in which a common cooling system is used for cooling both the magnet and the target region. This is achievable by the use of a flow-cooled system in which a coolant flows between one and the other of the first and second parts. Since the first part is in thermal communication with the magnet, which generates the largest heat load, preferably the first part is upstream of the second part. Therefore the coolant fluid passes firstly through the first part and then moves downstream to cool the second part. Although the target region may comprise a detector, or other apparatus/devices, preferably the target region is adapted to retain a sample when in use. Such a sample may be retained within a sample holder. This sample holder may or may not also form part of the target region.

Typically the magnet is contained within a cryostat. Preferably such a cryostat comprises at least one radiation shield. The flow path in this case is preferably arranged to further comprise a third part in thermal communication with the at least one radiation shield. Thus the coolant fluid is preferably used to cool not only the magnet and the target, but also the at least one radiation shield. Typically the flow path divides from a common path within which the first part is located into at least two separate paths within one of which is located the second part and another one of which is located the third part. Thus some of the coolant flows within the second part and some within the third part, whereas all of the coolant flows within the first part.

The third part may also be used to cool further apparatus within the cryostat such as current leads for supplying electrical current to the magnet. It will be appreciated that such a magnet is typically a superconducting magnet operative at cryogenic temperatures, including 7 Kelvin and below, and particularly liquid helium temperatures (4.2 Kelvin).

Since not all of the fluid flows through each of the first, second and third parts, preferably the system further comprises a flow controller which is adapted to provide a predetermined flow rate of coolant within one or more of the first, second and third parts of the system. The flow controller may comprise a variable flow impedance although a static localised flow impedance may be used (such as a narrowed portion of conduit) where a predefined steady-state flow in each of the parts of the system is required.

Typically the second part comprises a heat exchanger with which a target, such as a sample holder, is in thermal communication. Heat exchange is therefore used to cool the sample via the sample holder. In order to provide enhanced control over the temperature within the target region, a heater may be provided within the target region such that the heat produced, in combination with the cooling effect of the coolant in the second part of the cooling system, causes the target region to be held at a predetermined temperature. The predetermined temperature may therefore lie in a range bounded by the coolant temperature and ambient temperature. This allows the target region to be maintained at a temperature substantially the same as that of the magnet itself, or operated at a higher temperature including room temperature.

In order to provide accurate control over the temperature within the target region, preferably the system further comprises a temperature sensor located within the target region, together with a temperature controller which is used to control the heater in response to signals received from the temperature sensor when in use. If a variable flow impedance is provided then the temperature controller might be used to control the flow impedance also.

The magnet is preferably located within a cryostat vacuum chamber and, when cooling a sample, the system preferably comprises a sample vacuum chamber in the target region. The sample vacuum chamber is preferably independent of the cryostat vacuum chamber and therefore the temperature and pressure of each of these chambers may be controlled independently of one another.

In most cases, the magnet is provided in the form of a solenoid magnet having a bore within which the target region is located. In some applications it is desirable to allow radiation (electromagnetic or particle beam) to be transmitted to and/or received from a sample when located within the target region and therefore in this case the system preferably further comprises at least a first window position so as to allow radiation to be transmitted and/or received from the sample. A second window located on the opposite side of the sample with respect to the first is also preferably provided so as to allow radiation to be received by the sample through the first window, to pass through the sample and then to pass through the second window for monitoring. Thus reflective and transmissive monitoring using electromagnetic radiation (including visible, ultra-violet, infra-red light, and other longer and shorter wavelengths) or particle beams can be achieved.

For such monitoring, the magnet system may be adapted for use upon an optical bench and is preferably provided with mountings for fitment to such an optical bench. In known magnet systems for use upon optical benches, a fixed orientation with respect to the bench is required due to the need for the cooling systems to be arranged in a particular orientation. This is particularly the case where liquid coolants are used within the system, such as when liquid helium is used as a coolant, not only due to its liquid state, but also since it may be within a superfluid state. In the present case however, the coolant fluid is preferably within the gaseous form (even if not exclusively so due to localised condensation), and the system may be adapted to be operational in vertical and horizontal orientations with respect to a nominal axis. This is advantageous since it allows greater versatility in terms of performing experiments in particular upon target samples. For example a microscope may be used to view the sample by placing the objective lens inside the bore of the magnet system and then ability to orient the system either horizontally or vertically allows greater ease of use of a microscope or indeed other equipment.

The flow of coolant fluid within the cooling system is preferably arranged to be continuous such that the system is a "continuous flow" system. However, a discontinuous flow in one or more parts of the system may be used in certain circumstances.

Due to the flow of coolant fluid, the magnet is cooled by thermal conduction rather than being placed within a large bath of liquid coolant. The magnet is separated from the coolant by a high thermal conductivity member through which heat flows from the magnet. To achieve this, the magnet is preferably surrounded by an annular chamber which comprises the first part of the cooling system through which the coolant flows when in use. Thus the surface area of the high thermal conductivity member may be maximised so as to produce a strong cooling effect.

The target region may comprise a sample support for receiving a sample holder within which a sample is retained when in use. This support may be cooled using a heat exchanger, preferably in combination with a heater and temperature controller as described above.

Whilst, when in use, the coolant preferably flows continually, the system may be arranged such that the coolant is supplied to the flow path from a coolant reservoir. In this case the maximum operational period of the system is determined by the amount of coolant within the reservoir. In an alternative case, the cooling system may be a closed loop system such that, after passing through the flow path, the coolant is refrigerated and recirculated repeatedly through the flow path. A mechanical refrigerator could be used for refrigerating the coolant for recirculation although it will be appreciated that other cooling systems could be used to provide a similar effect.

Preferably the coolant is a cryogenic fluid, such fluids including gases or liquids at cryogenic temperatures (below 100 Kelvin). The coolant may therefore be helium or nitrogen gas for example.

Some examples of magnet systems according to the present invention will now be described with reference to the accompanying drawings, in which:-
Figure 1 is a first example of a flow-cooled system; and,
Figure 2 is a second example, using recirculated coolant.

### Description of Examples

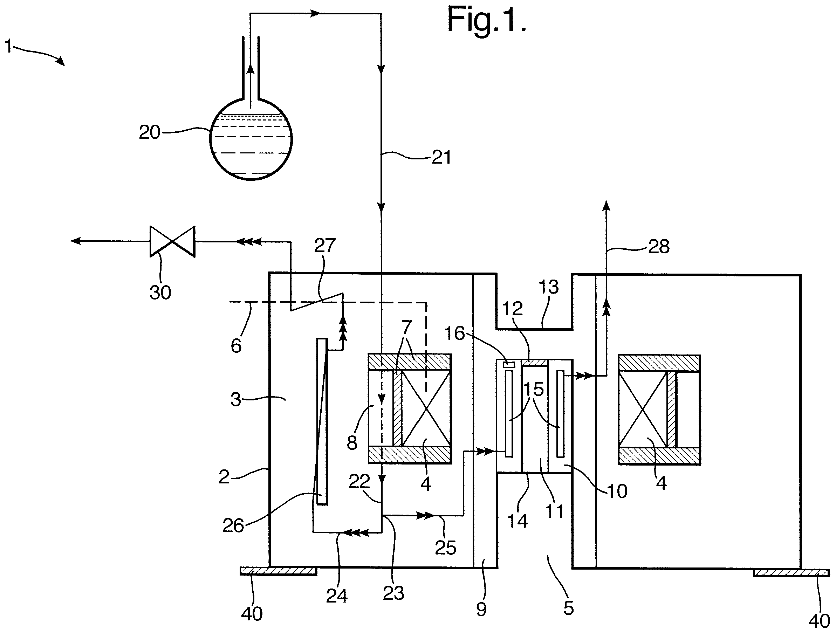

With reference to Figure 1, an example system according to the invention is generally indicated at 1. The system described within the present example is an "MO station" allowing optical monitoring to be performed upon a sample held within a magnetic field.

A cryostat 2 is provided, this containing a main vacuum chamber 3 within which is positioned a magnet 4. The cryostat 2 and magnet 4 are formed in a solenoid configuration so as to provide a bore 5 running substantially centrally through the magnet 4 and cryostat 2.

The magnet 4 is a superconducting solenoid magnet producing a magnetic field strength of about 5 Tesla. The magnet his energised using current leads 6 (shown as a dashed line). The magnet may operate in a "persistence" mode as is known in the art. The magnet 4 is bounded by walls 7 having a high thermal conductivity. In this case the walls are manufactured from high purity copper although of course the magnet windings are electrically insulated from the walls 7. Around the outer periphery of the magnet 4, beyond a dividing part of the walls 7, an annular chamber 8 is provided about the magnet periphery. In use coolant gas flows through the annular chamber 8 so as to cool the magnet 4. In the present example gaseous helium is used as the coolant. It is not essential that the helium is in its gaseous form to cool the magnet. Indeed the system may be arranged such that the annular chamber 8 is filled with liquid helium in an alternative embodiment. Gaseous helium is used in the present example since this allows the magnet to be oriented horizontally or vertically.

Within the bore 5, a sample vacuum chamber 9 is located. This can be thought of a separate cryostat within the cryostat 2. The vacuum chamber 9 is generally cylindrical in form such that outer wall of the cylinder conforms with the wall of the bore 5 (although it is separated therefrom by a small gap to provide thermal insulation). At least part of the inner wall is formed by a removable sample support 10, this also having generally cylindrical geometry including a central sample support bore 11. This bore 11 has a narrower diameter than that of the bore 5. At one end (the upper end in Figure 1) of the sample support 10, an alumina (sapphire) sample holder 12 is located. This retains a sample when in use centrally and at the end of the support bore 11. In the present case the sample is held at the same pressure as the vacuum chamber 9 within which it is located although this is not essential and the sample can be sealed within a dedicated pressure environment.

The sample support 10 is positioned such that the sample holder 12 is located beneath a first window 13 (glass) in an upper central wall of the sample vacuum chamber 9. At the opposite end of the sample support 10 to the sample holder 12 the support bore 11 is sealed by a second window 14, also made from glass. The first and second windows 13, 14 allow electromagnetic radiation to pass from one side of the cryostat along the bores 5 and 11, through the sample 12 and to the other side of the cryostat. This allows monitoring of the sample in terms of optical observations or measurements of the optical behaviour of the sample within the sample holder 12. One such application is in making optical measurements upon "quantum dot" samples by external illumination with light emitting diode or laser devices.

Within the walls of the sample holder 12, a heat exchanger 15 is provided, this taking the form of a helical flow path formed by opposed walls cut as a meshing thread with the path defining a narrow helical gap between the walls. A heater 16 is also provided adjacent to the sample holder 12, together with a temperature sensor (not shown). The cooling system for the apparatus according to the invention is now described.

In the present example the coolant is gaseous helium at ambient pressure and at a temperature of approximately 4.2 Kelvin. Lower temperature helium could be used (such as 2 Kelvin) although to retain the gaseous state the system would need to be operated at low pressure. The gaseous helium is provided from a helium reservoir 20 shown schematically in Figure 1. The helium is pumped from the reservoir 20 along a supply conduit 21 and into the cryostat 2 where it opens through a port into the annular chamber 8 adjacent the conducting walls 7 of the magnet 4. The annular chamber 8 operates as a "first part" of the flow path, this being in thermal communication with the magnet and helium entering the annular chamber therefore cools the magnet by contact with the walls 7. The helium then exits the annular chamber 8 via an exit conduit 22 having a port which is distal from the opening of the supply conduit into the chamber 8. Note in Figure 1 that the exit and supply conduits are shown one beneath the other only for simplicity purposes within the figure.

At a branch point 23, downstream of the annular chamber 8, the exit conduit divides into a cryostat conduit 24 and a sample conduit 25. Although the branch point is shown in Figure 1, it will be appreciated that a similar effect can be achieved by connecting the cryostat and sample conduits 24 and 25 to different parts of the annular chamber 8 (through respective ports), thereby removing the need for the exit conduit 22 and branch 23.

The purpose of the cryostat conduit is to take some of the coolant gas and use its cooling effect to cool further parts of the cryostat apparatus. In the present case, the cryostat conduit 24 is placed in thermal communication with the cryostat radiation shields generally indicated at 26. Thereafter, further downstream, the coolant is brought into thermal communication with the current leads 6 of the magnet 4, as indicated at 27. In each case suitable heat exchangers may be used to maximise the cooling effect. Having cooled the current leads 6, the cryostat conduit 24 passes out of the cryostat and through a check valve 30. The check valve provides a localised flow impedance and therefore controls the relative amounts of fluid flowing in each of the cryostat and sample conduits 24, 25. The check valve is not essential if the natural flow impedance of the cooling system as a whole is arranged to provide the correct division of coolant flow rates between the cryostat conduit 24 and sample conduit 25. As is known, the impedance of the conduits is a function of their length and cross section and one or each of these can be arranged accordingly.

Returning once more to the branch point 23, the sample conduit 25 (which represents a "second part" of the flow path), is arranged to open through a port into the helical threaded space defining the heat exchanger 15 within the sample support 10. The helium coolant gas therefore flows through the helical path of the heat exchanger and cools the sample support 10 and, by conduction, the sample holder 12. A venting portion 28 of the sample conduit carries the coolant gas from a port in a distal part of the heat exchanger 15 with respect to the position of the entry port, out of the cryostat 2 to a venting location.

The sample 12 is therefore cooled by the operation of the heat exchanger 15 as a result of the large surface area provided by the helical flow path. The temperature of the sample 12 is a function of the temperature and flow rate of the coolant gas, this being controlled at least in part by the check valve 30. In order to provide more accurate control of the temperature of the sample in the sample holder 12, the heater 16 is used in conjunction with the cooling effect of the heat exchanger 15 using an appropriate control system and temperature sensor (not shown) so as to ensure that the sample is subjected to a predetermined temperature or temperature cycle. This can be performed using a microprocessor and a feedback loop.

As is illustrated in Figure 1, the walls of the vacuum chamber 9 and the geometry of the sample support 10 are such that the first window 13 is positioned in close proximity to the sample within the sample holder 12. This allows optical equipment such as a microscope to be brought close to the sample within the sample holder 12. In addition, the windows 13 and 14 allow electromagnetic radiation to impinge upon and be transmitted by the sample either in a reflective or transmissive mode. This allows the optical properties of a sample to be measured as a function of magnetic field in terms of reflection and transmission.

The cooling of the apparatus using the cooling system (comprising the conduits, heat exchangers and so on) will now be described. Helium gas is pumped through the conduit by a pumping system which may be provided either within a common part of the flow path such as within the supply conduit 21, or in each of the cryostats and sample conduits 24, 25 respectively. As shown in Figure 1, helium enters the supply conduit 21 (denoted by a single headed arrow) and passes into the annular chamber 8 of the magnet system. Within the chamber 8, heat exchange occurs with the walls 7 and therefore the magnet 4 such that the helium absorbs heat from the magnet, therefore cooling it. The helium then passes out of the annular chamber 8 and reaches the branching point 23. A portion of the helium (denoted by doubled headed arrows) passes along the sample conduit and into the heat exchanger 15 whereby the sample holder 12 is cooled. This raises the temperature of the helium and it then passes beyond the heat exchanger 15 and vents outsides the cryostat through the venting portion 28. The vented helium may be collected for further use if desired, outside the apparatus.

The conduits 21 and 22 through which all of the coolant flows may be thought of as a common part of the flow cooling system, this containing the first part in which the thermal communication of the magnet occurs. In the second part, within the sample conduit branch, the thermal communication with the sample holder 12 occurs. Part of the coolant branches along the cryostat conduit 24 and this performs heat exchange with the radiation shields 26 and the current leads 6 before exiting the cryostat through the check valve 30. The parts of the flow path within the cryostat conduit 24 that are in thermal communication with the radiation shields and current leads comprise a third part of the flow path. As for the venting via the venting portion 28 of the sample conduit, downstream of the check valve 30, the helium gas may also be collected for further use.

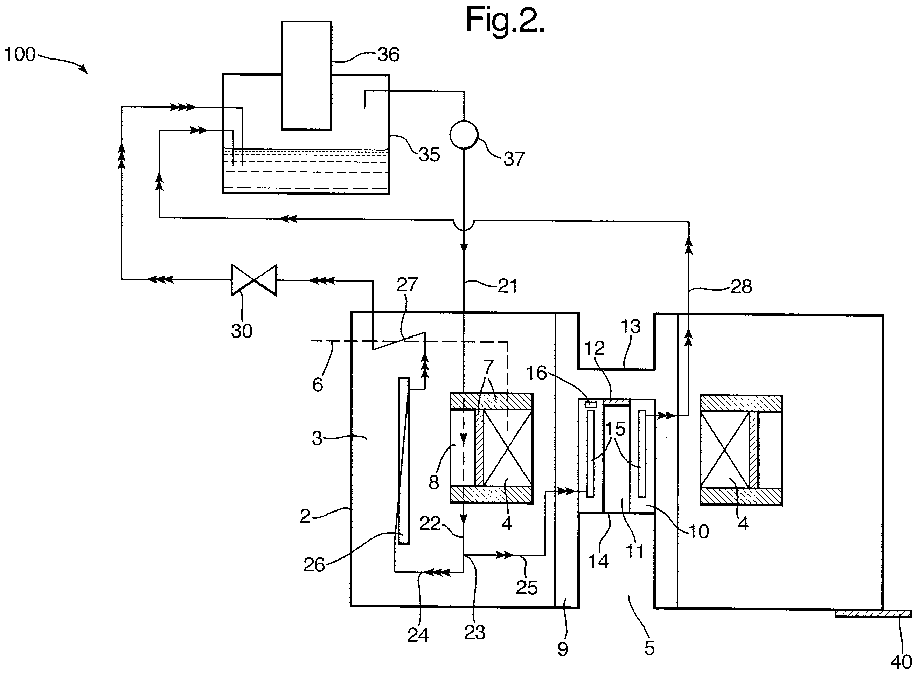

We turn now to a second embodiment of the present invention, this being illustrated within Figure 2.

As will be appreciated from a consideration of the example described above in association with Figure 1, the continuous flow operation of the example there described is limited ultimately by the volume of liquid helium within the reservoir 20. In the second example now described, a recirculating system is provided this being able to effectively provide continuous operation with the system for an indefinite period.

Referring now to Figure 2, in which similar components as to Figure 1 are denoted by similar reference numerals, a continuous flow system is described. The second example is denoted by a reference numeral 100.

The reservoir of the first example is replaced in this example by a vessel 35 as shown in Figure 2. The vessel 35 contains a reservoir of liquid helium although, unlike in the first example, in this case the vessel is cooled by a mechanical refrigerator 36. The mechanical refrigerator may take a number of forms that are known in the art although in the present case a three-stage pulse tube refrigerator is used. This maintains the vessel 35, and the helium within it, at the desired operational temperature (about 4.2K for ambient pressure). As is also illustrated in Figure 2, a pump 37 is provided within the supply conduit 21.

In this example, the vessel 35 is sealed from the external environment and thermally insulated therefrom also, and the pump 37 is operative to supply gaseous helium along the supply line 21. As before, the valve 30 controls the relative flow between the two conduits 24, 25. Unlike in the previous example however, where each of these conduits was vented either to the external atmosphere or to a collection system, in the present example the gas is returned to the vessel 35 in each case where it is cooled again by the mechanical refrigerator 36 which maintains the temperature of the vessel such that the helium entering the supply conduit 21 is at a sufficiently low temperature. As in the case of Figure 1, the Figure 2 example is also extremely schematic.

In a practical system, as would be appreciated by one of ordinary skill in the art, greater thermal efficiency can be achieved by techniques such as using the cooling effect of the helium within the "exit" path so as precool the "entry" path of the gas flowing into the cryostat. This may be achieved for example by providing the venting portion 28 in Figure 1 along a similar path to the supply conduit 21 and in thermal communication therewith.

The abovedescribed examples have been discussed in connection with the use of helium, this is due to the present desired use of liquid helium for cooling superconducting magnets and performing certain low temperature experiments. However, the system may also be used with other cryogenic coolants such as nitrogen at for example 77 Kelvin rather than 4.2 Kelvin. The systems are also described using approximately ambient pressures, whereas it will be appreciated that by using non-ambient pressures within the cooling system, different cooling temperatures may be achieved. Whilst the apparatus described in the examples is in relation to an experimental magnet for optical experiments, it will be appreciated that the principle underlying how the system is cooled may be applied to magnet systems including nuclear magnetic residence and magnetic residence imaging systems.

The present examples are particularly useful for performing magneto-optical experiments on an optical bench and for this reason in each example, as is shown in Figure 1, mountings 40 may be provided such that the system may be attached to an optical bench. In Figure 1 the bore 5 is oriented substantially vertically. Since the examples described herein use gaseous helium and therefore there is no or at least little liquid present within the cryostat itself, the cryostat may therefore be mounted such that the bore is oriented substantially horizontally which is particularly useful in the event if experiments are to be performed for example involving laser beams passing along an optical bench.

## Claims

1. A flow-cooled magnet system (1) comprising:-
a magnet (4) for generating a magnetic field in a target region;
a cooling system comprising a flow path for a cryogenic coolant fluid, the flow path having:-
(i) a first part (21) arranged in thermal communication with the magnet (4), and
(ii) a second part (25) in thermal communication with the target region, the system being arranged such that each of the magnet (4) and target region are cooled by the flow of the cryogenic coolant fluid in the first (21) and second (25) parts of the cooling system, **characterised in that**
the magnet (4) is cooled by thermal conduction and the magnet (4) is separated from the cryogenic coolant fluid by a high thermal conductivity member (7) through which heat flows from the magnet (4).

2. A magnet system according to claim 1, wherein the first part (21) is upstream of the second part (25).

3. A magnet system according to claim 1 or claim 2, wherein the target region is adapted to retain a sample when in use.

4. A magnet system according to any of the preceding claims, wherein the magnet is contained within a cryostat (2) comprising at least one radiation shield, wherein the flow path further comprises a third part (24) in thermal communication with the at least one radiation shield (26), and wherein the flow path divides from a common path (22) within which the first part is located, into at least two separate paths, within one of which is located the second part (25) and another one of which is located the third part (24).

5. A magnet system according to claim 4, wherein the flow path is divided such that some of the coolant flows through the second part (25) and some through the third part (24).

6. A magnet system according to claim 4 or claim 5, further comprising current leads (6) for supplying electrical current to the magnet, and wherein the third part (24) is in thermal communication with the current leads so as to cool the current leads when in use.

7. A magnet system according to any of claims 4 to 6, further comprising a flow controller adapted to provide a predetermined flow of coolant within one or more of the first, second and third parts of the system.

8. A magnet system according to claim 7, wherein the flow controller comprises a variable flow impedance or a static localised flow impedance.

9. A magnet system according to any of the preceding claims, wherein the second part (25) comprises a heat exchanger (15) with which a sample is in thermal communication.

10. A magnet system according to any of the preceding claims, wherein a heater (16) is provided within the target region such that the heat produced, in combination with the cooling effect of the coolant in the second part of the cooling system, allows the target region to be held at a predetermined temperature.

11. A magnet system according to claim 10, wherein the predetermined temperature lies in a range from the coolant temperature to ambient temperature.

12. A magnet system according to claim 9 or claim 10, wherein the target region further comprises a temperature sensor and a temperature controller is provided for controlling the heater in response to signals received from the temperature sensor.

13. A magnet system according to any of the preceding claims, wherein the magnet is located within a cryostat (2) having a vacuum chamber (3), and wherein a sample vacuum chamber (9) is provided as a target region for containing the second part of the coolant system and, when in use, a sample to be monitored, and wherein the sample vacuum chamber (9) is independent of the cryostat vacuum chamber (3).

14. A magnet system according to claim 13, wherein the temperature and pressure of the sample vacuum chamber are each controllable independently of the temperature and pressure within the cryostat vacuum chamber.

15. A magnet system according to any of the preceding claims, wherein the magnet is a solenoid magnet having a bore (5) and wherein the target region is located within the bore.

16. A magnet system according to any of the preceding claims, further comprising at least a first window (13) positioned to allow electromagnetic radiation to be transmitted and/or received from a sample when located in the target region.

17. A magnet system according to claim 16, further comprising a second window (14) located on the opposite side of the sample with respect to the first window (13) so as to allow electromagnetic radiation to be received by the sample through the first window, to pass through the sample and then pass through the second window for monitoring.

18. A magnet system according to any of the preceding claims, further comprising mountings for fitment of the system to an optical bench.

19. A magnet system according to any of the preceding claims, wherein the system is defined by a nominal axis and the system is adapted to be operational with the axis orientated substantially vertically and substantially horizontally.

20. A magnet system according to any of the preceding claims, wherein the system is a continuous flow system adapted such that the coolant flows through the cooling system continually when in use.

21. A magnet system according to any of the preceding claims, wherein the magnet is surrounded by an annular chamber (8) comprising the first part of the cooling system through which the coolant flows when in use.

22. A magnet system according to any of the preceding claims, wherein the target region further comprises a sample support (10) for receiving a sample holder within which a sample is retained.

23. A magnet system according to any of the preceding claims, wherein the coolant is supplied to the flow path from a coolant reservoir.

24. A magnet system according to any of claims 1 to 20, wherein the cooling system is a closed loop system such that, after passing through the flow path, the coolant is refrigerated and re-circulated repeatedly through the flow path.

25. A magnet system according to claim 24, further comprising a mechanical refrigerator (36) for refrigerating the coolant for recirculation.

26. A magnet system according to any of the preceding claims, wherein the coolant is a cryogenic fluid.

27. A magnet system according to claim 26, wherein the coolant is a gas.

28. A magnet system according to claim 27, wherein the coolant is helium or nitrogen gas.

## Patentansprüche

1. Strömungsgekühltes Magnetsystem (1), Folgendes umfassend:
einen Magneten (4) zum Erzeugen eines Magnetfelds in einem Zielbereich;
ein Kühlsystem, umfassend einen Strömungspfad für ein kryogenes Kühlmittelfluid, wobei der Strömungspfad Folgendes aufweist:
(i) einen ersten Teil (21), angeordnet in thermischer Kommunikation mit dem Magneten (4), und
(ii) einen zweiten Teil (25) in thermischer Kommunikation mit dem Zielbereich, wobei das System derart angeordnet ist, dass sowohl der Magnet (4) als auch der Zielbereich durch die Strömung des kryogenen Kühlmittelfluids in dem ersten (21) und dem zweiten (25) Teil des Kühlsystems gekühlt werden, **dadurch gekennzeichnet, dass** der Magnet (4) durch Wärmeleitung gekühlt wird und der Magnet (4) durch ein hochwärmeleitfähiges Element (7), durch welches Wärme von dem Magneten (4) strömt, von dem kryogenen Kühlmittelfluid getrennt ist.

2. Magnetsystem nach Anspruch 1, wobei der erste Teil (21) dem zweiten Teil (25) vorgelagert angeordnet ist.

3. Magnetsystem nach Anspruch 1 oder 2, wobei der Zielbereich angepasst ist, im Gebrauch eine Probe zu halten.

4. Magnetsystem nach einem der vorhergehenden Ansprüche, wobei der Magnet in einem Kryostat (2) enthalten ist, der wenigstens einen Strahlungsschutzschild umfasst, wobei der Strömungspfad ferner einen dritten Teil (24) in thermischer Kommunikation mit dem wenigstens einen Strahlungsschutzschild (26) umfasst, und wobei sich der Strömungspfad von einem gemeinsamen Pfad (22), in dem der erste Teil angeordnet ist, in wenigstens zwei separate Pfade teilt, wobei der zweite Teil (25) in einem von diesen angeordnet ist und der dritte Teil (24) in einem anderen von diesen angeordnet ist.

5. Magnetsystem nach Anspruch 4, wobei der Strömungspfad derart aufgeteilt ist, dass ein Teil des Kühlmittels durch den zweiten Teil (25) strömt und ein Teil durch den dritten Teil (24) strömt.

6. Magnetsystem nach Anspruch 4 oder 5, ferner umfassend Stromkabel (6) zum Bereitstellen eines elektrischen Stroms an den Magneten, und wobei der dritte Teil (24) in thermischer Kommunikation mit den Stromkabeln steht, um die Stromkabel im Gebrauch zu kühlen.

7. Magnetsystem nach einem der Ansprüche 4 bis 6, ferner umfassend eine Strömungsregelvorrichtung, angepasst zum Bereitstellen einer vorgegebenen Kühlmittelströmung in dem ersten, dem zweiten und/oder dem dritten Teil des Systems.

8. Magnetsystem nach Anspruch 7, wobei die Strömungsregelvorrichtung eine variable Strömungsimpedanz oder eine statische lokalisierte Strömungsimpedanz umfasst.

9. Magnetsystem nach einem der vorhergehenden Ansprüche, wobei der zweite Teil (25) einen Wärmetauscher (15), mit dem eine Probe in thermischer Kommunikation steht, umfasst.

10. Magnetsystem nach einem der vorhergehenden Ansprüche, wobei eine Heizvorrichtung (16) in dem Zielbereich bereitgestellt ist, sodass die erzeugte Wärme in Kombination mit der Kühlwirkung des Kühlmittels in dem zweiten Teil des Kühlsystems es ermöglicht, den Zielbereich bei einer vorgegebenen Temperatur zu halten.

11. Magnetsystem nach Anspruch 10, wobei die vorgegebene Temperatur in einem Bereich von der Kühlmitteltemperatur bis zu der Umgebungstemperatur liegt.

12. Magnetsystem nach Anspruch 9 oder 10, wobei der Zielbereich ferner einen Temperatursensor umfasst und ein Temperaturregler zum Regeln der Heizvorrichtung als Reaktion auf von dem Temperatursensor empfangene Signale bereitgestellt ist.

13. Magnetsystem nach einem der vorhergehenden Ansprüche, wobei der Magnet innerhalb eines Kryostats (2) mit einer Unterdruckkammer (3) angeordnet ist, und wobei eine Proben-Unterdruckkammer (9) als ein Zielbereich zum Enthalten des zweiten Teils des Kühlmittelsystems und, wenn im Gebrauch, einer zu überwachenden Probe bereitgestellt ist, und wobei die Proben-Unterdruckkammer (9) von der Kryostat-Unterdruckkammer (3) unabhängig ist.

14. Magnetsystem nach Anspruch 13, wobei die Temperatur und der Druck der Proben-Unterdruckkammer jeweils unabhängig von der Temperatur und dem Druck in der Kryostat-Unterdruckkammer geregelt werden können.

15. Magnetsystem nach einem der vorhergehenden Ansprüche, wobei der Magnet ein Solenoid-Magnet mit einer Bohrung (5) ist und wobei der Zielbereich innerhalb der Bohrung angeordnet ist.

16. Magnetsystem nach einem der vorhergehenden Ansprüche, ferner umfassend wenigstens ein erstes Fenster (13), angeordnet, um zu ermöglichen, dass elektromagnetische Strahlung von einer Probe, wenn sie sich in dem Zielbereich befindet, übertragen und/oder empfangen werden kann.

17. Magnetsystem nach Anspruch 16, ferner umfassend ein zweites Fenster (14), das sich bezogen auf das erste Fenster (13) auf der anderen Seite der Probe befindet, um zu ermöglichen, dass elektromagnetische Strahlung durch das erste Fenster von der Probe empfangen werden kann, durch die Probe durchtritt und dann zum Überwachen durch das zweite Fenster durchtritt.

18. Magnetsystem nach einem der vorhergehenden Ansprüche, ferner umfassend Befestigungen zum Befestigen des Systems an eine optische Bank.

19. Magnetsystem nach einem der vorhergehenden Ansprüche, wobei das System durch eine Nennachse definiert ist und das System angepasst ist, funktionsfähig zu sein, wenn die Achse im Wesentlichen vertikal ist und wenn sie im Wesentlichen horizontal ist.

20. Magnetsystem nach einem der vorhergehenden Ansprüche, wobei das System ein Durchlaufsystem ist, derart angepasst, dass das Kühlmittel im Gebrauch durchgehend durch das Kühlsystem strömt.

21. Magnetsystem nach einem der vorhergehenden Ansprüche, wobei der Magnet von einer ringförmigen Kammer (8) umgeben ist, die den ersten Teil des Kühlsystems umfasst, durch das im Gebrauch das Kühlmittel strömt.

22. Magnetsystem nach einem der vorhergehenden Ansprüche, wobei der Zielbereich ferner eine Probenaufnahme (10) zum Aufnehmen einer Probenhalterung, in der eine Probe gehalten wird, umfasst.

23. Magnetsystem nach einem der vorhergehenden Ansprüche, wobei das Kühlmittel von einem Kühlmittelvorratsbehälter an den Strömungspfad bereitgestellt wird.

24. Magnetsystem nach einem der Ansprüche 1 bis 20, wobei das Kühlsystem ein geschlossenes Kreislaufsystem ist, sodass das Kühlmittel nach dem Durchlaufen des Strömungspfads gekühlt und wiederholt durch den Strömungspfad geleitet wird.

25. Magnetsystem nach Anspruch 24, ferner ein mechanisches Kühlelement (36) zum Kühlen des Kühlmittels für den Kreislauf umfassend.

26. Magnetsystem nach einem der vorhergehenden Ansprüche, wobei das Kühlmittel ein kryogenes Fluid ist.

27. Magnetsystem nach Anspruch 26, wobei das Kühlmittel ein Gas ist.

28. Magnetsystem nach Anspruch 27, wobei das Kühlmittel Helium- oder Stickstoffgas ist.

## Revendications

1. Système d'aimant refroidi par écoulement (1) comprenant :
un aimant (4) pour générer un champ magnétique dans une région cible ;
un système de refroidissement comprenant un chemin d'écoulement pour un fluide de refroidissement cryogénique, le chemin d'écoulement ayant :
(i) une première partie (21) agencée en communication thermique avec l'aimant (4), et
(ii) une deuxième partie (25) en communication thermique avec la région cible, le système étant agencé de sorte que chacun de l'aimant (4) et de la région cible soit refroidi par l'écoulement du fluide de refroidissement cryogénique dans la première (21) et la deuxième (25) partie du système de refroidissement, **caractérisé en ce que**
l'aimant (4) est refroidi par conduction thermique et l'aimant (4) est séparé du fluide de refroidissement cryogénique par un élément de haute conductivité thermique (7) à travers lequel la chaleur circule à partir de l'aimant (4).

2. Système d'aimant selon la revendication 1, dans lequel la première partie (21) est en amont de la deuxième partie (25).

3. Système d'aimant selon la revendication 1 ou la revendication 2, dans lequel la région cible est adaptée pour retenir un échantillon au moment de l'utilisation.

4. Système d'aimant selon l'une quelconque des revendications précédentes, dans lequel l'aimant est contenu à l'intérieur d'un cryostat (2) comprenant au moins un écran anti-rayonnement, dans lequel le chemin d'écoulement comprend en outre une troisième partie (24) en communication thermique avec le au moins un écran anti-rayonnement (26), et dans lequel le chemin d'écoulement se divise, à partir d'un chemin commun (22) à l'intérieur duquel est située la première partie, en au moins deux chemins séparés, à l'intérieur de l'un desquels est située la deuxième partie (25) et à l'intérieur de l'autre desquels est située la troisième partie (24).

5. Système d'aimant selon la revendication 4, dans lequel le chemin d'écoulement est divisé de sorte qu'une partie du fluide de refroidissement s'écoule à travers la deuxième partie (25) et qu'une partie s'écoule à travers la troisième partie (24).

6. Système d'aimant selon la revendication 4 ou la revendication 5, comprenant en outre des conducteurs de courant (6) pour fournir un courant électrique à l'aimant, et dans lequel la troisième partie (24) est en communication thermique avec les conducteurs de courant de façon à refroidir les conducteurs de courant au moment de l'utilisation.

7. Système d'aimant selon l'une quelconque des revendications 4 à 6, comprenant en outre un dispositif de régulation d'écoulement adapté pour assurer un écoulement prédéterminé de fluide de refroidissement à l'intérieur de l'une ou de plusieurs des première, deuxième et troisième parties du système.

8. Système d'aimant selon la revendication 7, dans lequel le dispositif de régulation d'écoulement comprend une impédance à écoulement variable ou une impédance à écoulement localisé statique.

9. Système d'aimant selon l'une quelconque des revendications précédentes, dans lequel la deuxième partie (25) comprend un échangeur de chaleur (15) avec lequel un échantillon est en communication thermique.

10. Système d'aimant selon l'une quelconque des revendications précédentes, dans lequel un dispositif de chauffage (16) est prévu à l'intérieur de la région cible, de sorte que la chaleur produite, en combinaison avec l'effet de refroidissement du fluide de refroidissement dans la deuxième partie du système de refroidissement, permette à la région cible d'être maintenue à une température prédéterminée.

11. Système d'aimant selon la revendication 10, dans lequel la température prédéterminée se situe dans une plage allant de la température du fluide de refroidissement à la température ambiante.

12. Système d'aimant selon la revendication 9 ou la revendication 10, dans lequel la région cible comprend en outre un capteur de température et un dispositif de régulation de température est prévu pour réguler le dispositif de chauffage en réponse à des signaux reçus du capteur de température.

13. Système d'aimant selon l'une quelconque des revendications précédentes, dans lequel l'aimant est situé à l'intérieur d'un cryostat (2) ayant une chambre à vide (3), et dans lequel une chambre à vide d'échantillon (9) est prévue en tant que région cible pour contenir la deuxième partie du système de refroidissement et, au moment de l'utilisation, un échantillon à surveiller, et dans lequel la chambre à vide d'échantillon (9) est indépendante de la chambre à vide de cryostat (3).

14. Système d'aimant selon la revendication 13, dans lequel la température et la pression de la chambre à vide d'échantillon peuvent chacune être régulées indépendamment de la température et de la pression à l'intérieur de la chambre à vide de cryostat.

15. Système d'aimant selon l'une quelconque des revendications précédentes, dans lequel l'aimant est un aimant solénoïde ayant un alésage (5) et dans lequel la région cible est située à l'intérieur de l'alésage.

16. Système d'aimant selon l'une quelconque des revendications précédentes, comprenant en outre au moins une première fenêtre (13) positionnée pour permettre à un rayonnement électromagnétique d'être transmis et/ou reçu à partir d'un échantillon, lorsqu'elle est située dans la région cible.

17. Système d'aimant selon la revendication 16, comprenant en outre une seconde fenêtre (14) située du côté opposé de l'échantillon par rapport à la première fenêtre (13), de façon à permettre à un rayonnement électromagnétique d'être reçu par l'échantillon par l'intermédiaire de la première fenêtre, de traverser l'échantillon puis de traverser la seconde fenêtre pour une surveillance.

18. Système d'aimant selon l'une quelconque des revendications précédentes, comprenant en outre des fixations pour le montage du système sur un banc optique.

19. Système d'aimant selon l'une quelconque des revendications précédentes, dans lequel le système est défini par un axe nominal et le système est adapté pour être opérationnel avec l'axe orienté sensiblement verticalement et sensiblement horizontalement.

20. Système d'aimant selon l'une quelconque des revendications précédentes, dans lequel le système est un système à écoulement continu adapté de sorte que le fluide de refroidissement s'écoule à travers le système de refroidissement en continu au moment de l'utilisation.

21. Système d'aimant selon l'une quelconque des revendications précédentes, dans lequel l'aimant est entouré par une chambre annulaire (8) comprenant la première partie du système de refroidissement à travers lequel le fluide de refroidissement s'écoule au moment de l'utilisation.

22. Système d'aimant selon l'une quelconque des revendications précédentes, dans lequel la région cible comprend en outre un support d'échantillon (10) pour recevoir un porte-échantillon à l'intérieur duquel est retenu un échantillon.

23. Système d'aimant selon l'une quelconque des revendications précédentes, dans lequel le fluide de refroidissement est fourni au chemin d'écoulement provenant d'un réservoir de fluide de refroidissement.

24. Système d'aimant selon l'une quelconque des revendications 1 à 20, dans lequel le système de refroidissement est un système à boucle fermée de sorte que, après avoir traversé le chemin d'écoulement, le fluide de refroidissement est réfrigéré et remis en circulation de façon répétée à travers le chemin d'écoulement.

25. Système d'aimant selon la revendication 24, comprenant en outre un réfrigérateur mécanique (36) pour réfrigérer le fluide de refroidissement pour une recirculation.

26. Système d'aimant selon l'une quelconque des revendications précédentes, dans lequel le fluide de refroidissement est un fluide cryogénique.

27. Système d'aimant selon la revendication 26, dans lequel le fluide de refroidissement est un gaz.

28. Système d'aimant selon la revendication 27, dans lequel le fluide de refroidissement est du gaz hélium ou azote.
